# EUROPEAN PATENT APPLICATION

(11) **EP 4 686 224 A1**
(43) Date of publication of application: **28.01.2026**
(21) Application number: 24774522.7
(22) Date of filing: 15.02.2024
(51) Int. Cl.: H04R 3/00, B60Q 5/00, H03G 3/00

(54) **SOUND VOLUME CONTROL DEVICE**

(30) Priority: 20.03.2023 JP 2023044240
(71) Applicant: Denso Electronics Corporation, Anjo-city, Aichi 446-8503 (JP)
(72) Inventor: YAMAMOTO Chikara, Anjo-city, Aichi 446-8503 (JP); TANI Shinji, Anjo-city, Aichi 446-8503 (JP)
(74) Representative: Kuhnen & Wacker Patent- und Rechtsanwaltsbüro PartG mbB
(86) International application number: PCT/JP2024/005366
(87) International publication number: WO 2024/195377

(57) **Abstract**

The volume control device is included in a sound generation system (8), which controls a sound generator (80) to generate a sound based on sound data (Dsd). The volume control device controls a volume (Vp) of the sound data. The volume control device includes a target volume storage unit (181) that sequentially stores and accumulates target volumes (d) that are repeatedly set at a predetermined period (T1). The volume control device also includes a volume determination unit (183) that sequentially determines, as the volume of the sound data, a moving average of the target volumes accumulated in the target volume storage unit during a predetermined average target period (Tav).

## Description

### CROSS REFERENCE TO RELATED APPLICATION

This application is based on Japanese Patent Application No. 2023-044240 filed on March 20, 2023, the disclosure of which is incorporated herein by reference.

### TECHNICAL FIELD

The present disclosure relates to a volume control device that controls a volume of sound data.

### BACKGROUND ART

As a volume control device, for example, a vehicle approach warning device described in Patent Literature 1 is known. The vehicle approach warning device described in Patent Literature 1 includes a data storage unit that stores sound source data, which is provided by PCM data, and generates sound by a sound generator (for example, a speaker) in accordance with the sound source data read from the data storage unit.

### PRIOR ART LITERATURE

### PATENT LITERATURE

Patent Literature 1: JP 2012-232699 A

### SUMMARY

When a volume control device gradually changes a volume, for example, it is conceivable that a time-to-volume table that defines a relationship between volume setting values and time is stored in advance in the volume control device. In this case, the volume control device gradually changes the volume by sequentially multiplying the sound source data by the volume setting value obtained from the time-to-volume table and outputting the result as sound data to the sound generator. For example, when the vehicle approach warning device disclosed in Patent Literature 1 gradually changes the volume based on the time-to-volume table in above-described method, it is necessary to store, in advance, the time-to-volume table in the vehicle approach warning device.

When performing a gradual change of volume using the time-to-volume table, if a target volume or a gradual change duration is required to be changed, a large number of time-to-volume tables need to be prepared and stored in the volume control device in advance. Usually, amount of data that can be stored in the volume control device is limited. In order to implement different patterns of gradual volume control while suppressing the amount of data to be stored, it is not desirable to complicate a calculation processing structure of the volume control device. These difficulties are studied by the inventors of the present disclosure. It should be noted that a gradual change in volume means a smooth change of volume.

In view of the above issues, an object of the present disclosure is to provide a volume control device that can execute various patterns of gradual volume change controls using the same calculation structure.

In order to achieve the above object, according to an aspect of the present disclosure, a volume control device is provided. The volume control device is included in a sound generation system, and the sound generation system controls a sound generator to generate a sound based on sound data. The volume control device controls a volume of the sound data, and the volume control device includes a target volume storage unit and a volume determination unit. The target volume storage unit is configured to store and accumulate target volumes repeatedly set at a predetermined period. The volume determination unit is configured to sequentially determine, as the volume of the sound data, a moving average of the target volumes accumulated in the target volume storage unit during a predetermined average target period.

According to the above configuration, it is possible to generate various gradual volume change patterns by changing the target volume or the average target period using the same calculation structure. Thus, it is possible to support various gradual volume change controls using the same calculation structure.

In some sections of the present application, some elements may be provided with reference symbols in parentheses. In this case, the reference symbol merely indicates an example of correspondence between the element and the specific configuration of the embodiment to be described later. Therefore, the present disclosure is not limited by the description of the reference symbols.

### BRIEF DESCRIPTION OF DRAWINGS

FIG. 1 is a block diagram showing a general configuration of a sound generation system according to a first embodiment.
FIG. 2 is a schematic diagram showing a buffer in which a target volume is temporarily stored and accumulated according to the first embodiment.
FIG. 3 is a diagram showing target volume stored in a buffer in a chronological order for each calculation cycle according to the first embodiment.
FIG. 4 is a schematic diagram in which (a) shows a buffer rewritten by a buffer clearing performed by a target volume storage unit, and (b) shows a buffer in which the latest target volume is stored after the buffer clearing is performed.
FIG. 5 is a diagram showing a change in target volume and a change in current volume in a first example of gradual change process of current volume.
FIG. 6 is a diagram showing a change in target volume and a change in current volume in a second example of gradual change process of current volume.
FIG. 7 is a diagram showing a change in target volume and a change in current volume in a third example of gradual change process of current volume.
FIG. 8 is a diagram showing a change in target volume and a change in current volume in a fourth example of gradual change process of current volume.
FIG. 9 is a diagram showing a change in target volume and a change in current volume in a fifth example of gradual change process of current volume.

### DESCRIPTION OF EMBODIMENTS

The following will describe embodiments of the present disclosure with reference to the accompanying drawings. In the following embodiments, the same or equivalent parts are denoted by the same reference symbols, and detailed explanations will be omitted.

### (First Embodiment)

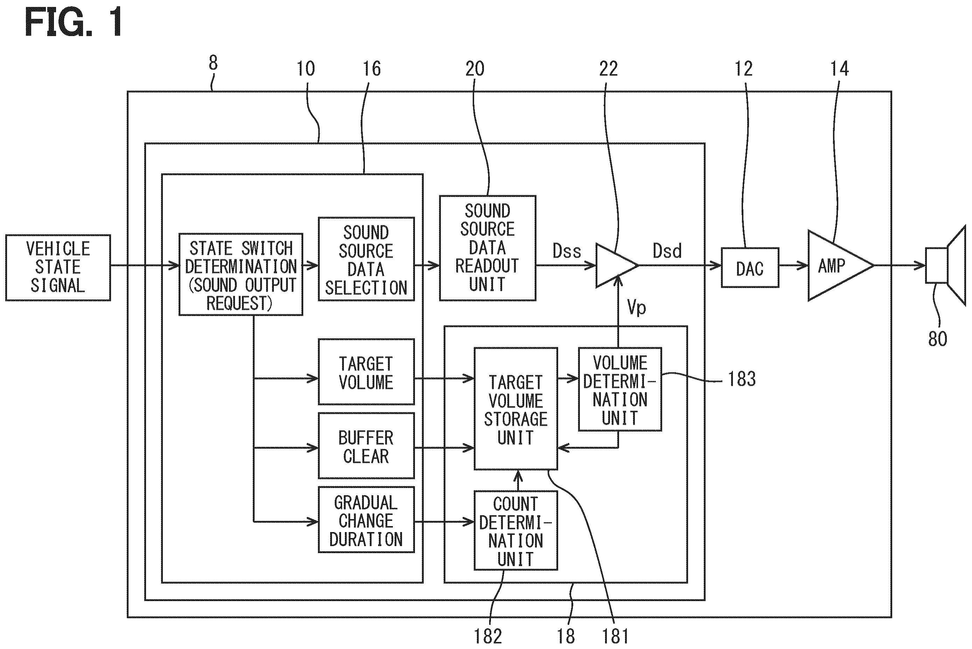

In the present embodiment, a sound generation system 8 shown in FIG. 1 is a warning device mounted on, for example, a hybrid vehicle or an electric vehicle. For example, the sound generation system 8 is electrically connected to a sound generator 80, such as a speaker or a buzzer, and causes the sound generator 80 to output various warning sounds.

The sound generation system 8 includes a microcomputer 10, a digital-to-analog converter 12, and a power amplifier 14. In the description of the present embodiment, the digital-to-analog converter 12 is also referred to as a DAC 12, and the power amplifier 14 is also referred to as an AMP 14.

The microcomputer 10 is an electronic control device, and is configured as an on-board microcomputer including a CPU, a RAM, a ROM, a non-volatile rewritable memory, and the like (not shown). The microcomputer 10 reads out and executes a computer program stored in the ROM or the non-volatile rewritable memory, which are non-transitory tangible storage medium. A method corresponding to the computer program is performed when the computer program is executed.

As shown in FIG. 1, the microcomputer 10 includes, as functional blocks, a sound generation instruction unit 16, a volume control unit 18, a sound source data readout unit 20, and a sound data generation unit 22. The sound generation instruction unit 16 determines whether to generate a warning sound based on, for example, a vehicle state signal obtained from a device arranged outside the microcomputer 10. For example, the vehicle state signal may be obtained from multiple sensors mounted on the vehicle.

When the sound generation instruction unit 16 determines that a notification sound should be generated, the sound generation instruction unit performs, at a time when the notification sound should be generated, a state switch determination whether to switch to a sound generation state or a sound generation request to request generation of sound.

Specifically, in the state switch determination or the sound generation request, the sound generation instruction unit 16 selects the sound source data Dss corresponding to the notification sound to be generated. For example, multiple different pieces of sound source data Dss are stored in advance in the memory of the microcomputer 10, and the sound generation instruction unit 16 selects one piece of predetermined sound source data Dss from the multiple pieces of sound source data Dss. The sound source data Dss is digital data. The sound source data Dss is waveform data constituting a digital sound waveform such as a PCM waveform that indicates a relationship between elapsed time and level. The level of digital sound waveform corresponds to a voltage of the analog signal corresponding to the sound waveform (that is, the analog sound waveform), and an amplitude of the level corresponds to a voltage amplitude of the analog sound waveform.

In addition to selecting the above-described sound source data Dss, the sound generation instruction unit 16 also determines the target volume d when generating the sound source data Dss and determines the gradual change duration (in other words, the fade time) required for the volume of sound generated based on the sound source data Dss reaches the target volume d.

When the sound generation instruction unit 16 determines that a notification sound should be generated, the sound generation instruction unit selects the sound source data Dss and determines the target volume d and the gradual change duration. Then, the sound generation instruction unit 16 instructs the volume control unit 18 of the determined target volume d and the gradual change duration.

The target volume d is a target value of volume and corresponds to the volume at which a sound source is required to be output. The target volume d is adjusted, for example, in accordance with the operating state of each system of the vehicle, in which the sound generation system 8 is mounted, and a periphery environment of the vehicle. The gradual change duration is a duration required for the volume to gradually change and reach the target volume d.

The sound source data readout unit 20 reads the sound source data Dss, which is selected by the sound generation instruction unit 16, from the memory of the microcomputer 10, and transfers the sound source data Dss to the sound data generation unit 22.

The volume control unit 18 functions as a volume control device that controls the volume of sound data Dsd output from the microcomputer 10 to the DAC 12. The volume control unit 18 determines a volume Vp by which the sound source data Dss is multiplied, based on the target volume d and the gradual change duration, which are instructed by the sound generation instruction unit 16. In the present embodiment, the volume Vp by which the sound source data Dss is multiplied may also be referred to as a current volume Vp. The volume control unit 18 repeatedly calculates and determines the current volume Vp at a predetermined calculation cycle T1. For example, the calculation cycle T1 of the current volume Vp is a constant value of 20 msec.

In the present embodiment, the current volume Vp is determined by calculating a moving average of the target volume d, and the calculation of moving average will be described in detail later.

In order to calculate the current volume Vp, the volume control unit 18 has a target volume storage unit 181, a count determination unit 182, and a volume determination unit 183.

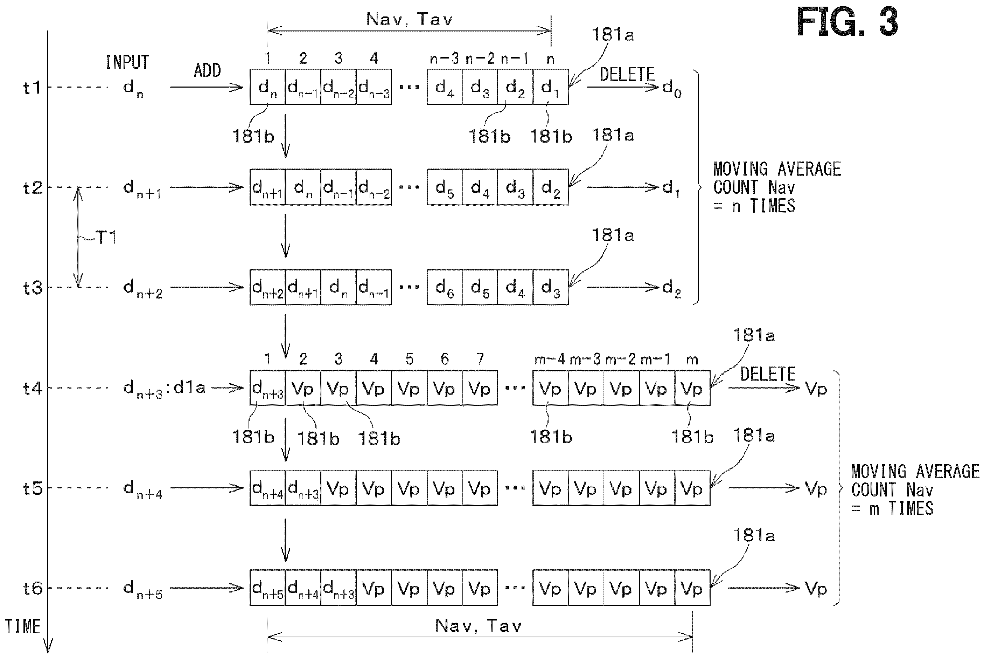

The count determination unit 182 determines an average target period Tav (see FIG. 3) based on the gradual change duration instructed by the sound generation instruction unit 16. The average target period Tav is a length of period during which the moving average calculation is executed. Basically, the gradual change duration becomes the average target period Tav.

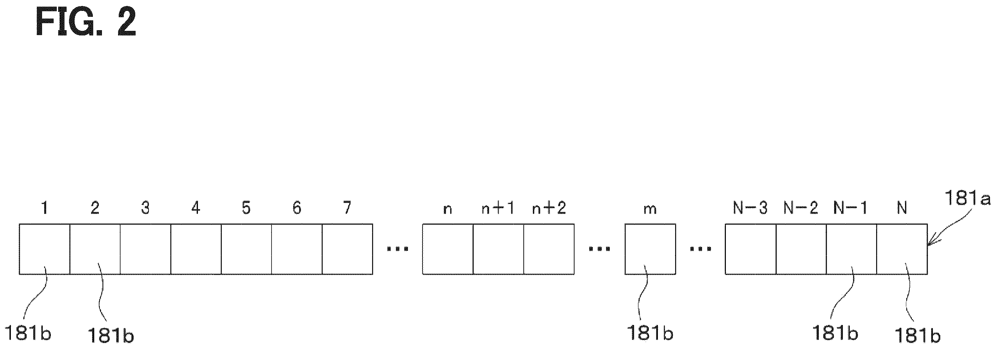

Then, the count determination unit 182 converts the average target period Tav into a moving average count Nav (see FIG. 3) thereby determining the moving average count Nav. The moving average count Nav is the number of times that the target volume d within the average target period Tav is repeatedly stored in a buffer 181a (see FIG. 2) for calculating the moving average. Details of the buffer 181a will be described below. Therefore, the moving average count Nav is the number of data pieces of the target volumes d for which the moving average is calculated.

Specifically, the moving average count Nav is calculated from the formula "Nav=Tav/T1" based on the average target period Tav and the calculation cycle T1. As described above, since the calculation cycle T1 is 20 msec, for example, when the average target period Tav is 1 sec, the moving average count is 50 times calculated by the formula "Nav = 1/0.02". The moving average count Nav corresponds to the average target period Tav in a one-to-one relationship, and the moving average count Nav is determined once the average target period Tav is determined.

As shown in FIG. 2 and FIG. 3, the target volume storage unit 181 has the buffer 181a which is a temporary storage unit for temporarily storing the target volume d. The target volume storage unit 181 repeatedly sets the target volume d at the calculation cycle T1. Repeatedly setting the target volume d means making the target volume d instructed by the sound generation instruction unit 16 into an instantaneous value divided for each calculation cycle T1. Therefore, the target volume d instructed by the sound generation instruction unit 16 has the same value as the target volume d set by the target volume storage unit 181. The calculation cycle T1 corresponds to a predetermined period of the present disclosure.

The target volume storage unit 181 sequentially stores and accumulates the target volume d set by the target volume storage unit 181 in the buffer 181a. In the present embodiment, the setting cycle for setting and storing the target volume d is the same as the calculation cycle T1 of the current volume Vp, and the current volume Vp is calculated every time the target volume d is set and stored.

For example, since the above-described moving average count Nav increases or decreases according to the gradual change duration, a capacity N of the buffer 181a (in other words, the maximum buffer number N) is set to a size that can store all of the target volume d for the maximum moving average count Nav. In the buffer 181a, among the maximum buffer number N, the necessary amount of necessary buffer number corresponding to the moving average count Nav is used to store the target volume d. FIG. 2 shows the buffer 181a, and FIG. 3 shows a temporal change in contents of the buffer 181a in which the target volume d is sequentially stored.

FIG. 3 shows the content stored in the buffer 181a for each calculation cycle T1. The contents stored in the buffer on lower side of the drawing sheet shows the later time. For example, in FIG. 3, from time t1 to time t3, the moving average count Nav is set to n times. Tt time t4, the moving average count Nav is increased from n times to m times, and from time t4 to time t6 the moving average count Nav is set to m times.

In FIG. 3, the remaining portion of buffer 181a other than a portion corresponding to a range of the moving average count Nav, which is the target of moving average calculation, is omitted. The subscripted d such as d0, d1, and dn+5 in FIG. 3 indicate a target volume d set for each calculation cycle T1, and the larger the subscript, the newer the target volume d. For example, dn+4 is the target volume d calculated one calculation cycle prior to the calculation cycle T1 of dn+5. In addition, n, m, and N shown in FIG. 2 to FIG. 4 are positive integers and have a relationship of n<m<N. As shown in FIG. 3, the average target period Tav is a period going back from the time point at which the latest target volume d is set, which is the latest one among repeatedly set target volumes d.

The volume determination unit 183 shown in FIG. 1 sequentially determines, as the current volume Vp, the moving average of target volumes d over the average target period Tav, among the target volume d stored in the buffer 181a by the target volume storage unit 181. The volume determination unit 183 calculates the moving average of target volumes d over the average target period Tav, and sequentially determines the calculated moving average value as the current volume Vp. The current volume Vp is repeatedly determined at the calculation cycle T1 as described above.

For example, at time t1 in FIG. 3, the volume determination unit 183 calculates the moving average of target volume d over the average target period Tav by dividing the sum of d1 to dn stored in the buffer 181a by the moving average count Nav, and sets the calculated value as the current volume Vp. In FIG. 3, at time t1, the moving average count Nav is n, so the current volume Vp is calculated as "Vp = (d1 + d2 +... + dn-1 + dn)/n".

The sound data generation unit 22 generates the sound data Dsd by multiplying the sound source data Dss, which is read by the sound source data readout unit 20, by the current volume Vp, which is determined by the volume determination unit 183. In the sound data Dsd obtained by multiplying the sound source data Dss by the current volume Vp, an amplitude of level of waveform corresponds to the current volume Vp. Thus, the sound data Dsd reflects the current volume Vp. Therefore, the current volume Vp determined by the volume determination unit 183 is also referred to as a volume of sound data Dsd. The sound data Dsd is waveform data obtained by adjusting the volume of sound source data Dss. Thus, similar to the sound source data Dss, the sound data Dsd is also waveform data constituting a digital sound waveform, such as a PCM waveform.

The sound data generation unit 22 sequentially outputs the generated sound data Dsd to the DAC 12.

The DAC 12 converts the sound data Dsd, which is digital data generated by the sound data generation unit 22, into an analog signal, and outputs the analog signal.

The AMP 14 supplies a current corresponding to the analog signal output from the DAC 12 to the sound generator 80, based on applying of a voltage from a constant voltage source (not shown). The sound generator 80 generates sound in response to the current being supplied from the AMP 14. In this manner, the sound generator 80 generates sound in accordance with the sound data Dsd reflecting the current volume Vp. The volume of sound generator 80 becomes equal to the current volume Vp determined by the volume determination unit 183.

The following will describe FIG. 3. As shown in FIG. 3, at time t1, the target volume storage unit 181 stores dn, which is the latest target volume d, in the buffer 181a. At the same time, the target volume storage unit 181 deletes d0, which was stored in the oldest storage location 181b in the buffer 181a, from the range of moving average count Nav set in the buffer 181a. From time t2 to time t6, the target volume storage unit 181 also performs a similar rewrite of the target volume d.

At time t4, the moving average count Nav is changed from n to m. When the moving average count Nav is changed, the target volume storage unit 181 executes a buffer clearing, which will be described later, before storing the new target volume d in the buffer 181a. Since there is one-to-one correspondence between the moving average count Nav and the target average period Tav, change of moving average count Nav means change of target average period Tav. For example, the buffer clearing may be instructed by the sound generation instruction unit 16 or may be executed without any instruction from the sound generation instruction unit 16.

The change of moving average count Nav means that the moving average count Nav used to calculate the current volume Vp in the previous control cycle is different from the moving average count Nav used to calculate the current volume Vp in the current control cycle.

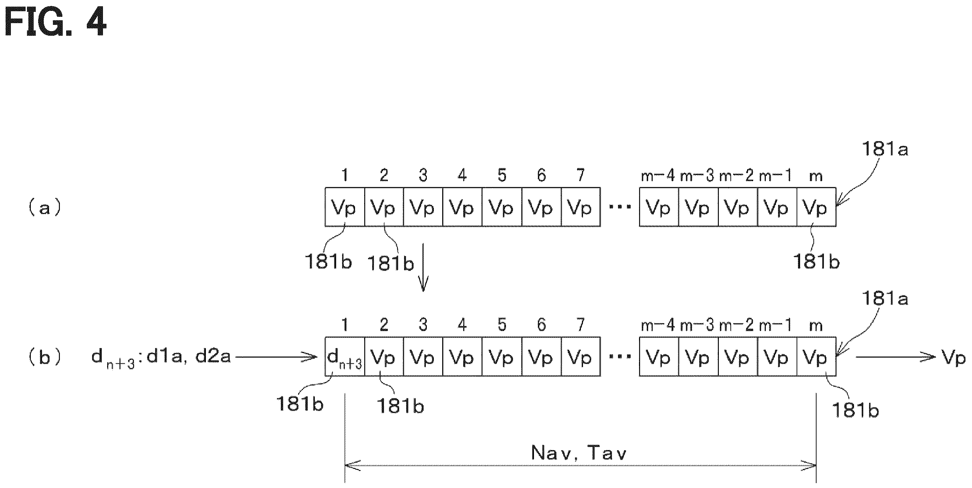

As shown in (a) of FIG. 4, the buffer clearing performed by the target volume storage unit 181 means rewriting the latest current volume Vp in all memory locations 181b of the target volume d within the range of moving average count Nav in the buffer 181a. The buffer clearing means setting all of the target volumes d within the changed average target period Tav of the buffer 181a to the latest current volume Vp. In the example of FIG. 3, the latest current volume Vp is a value calculated as the moving average of target volumes d (specifically, d3, d4,..., dn+1, dn+2) at time t3. The time t3 is prior to the time t4 by one calculation cycle T1.

At time t4, the target volume storage unit 181 executes buffer clearing as shown in (a) of FIG. 4. Then, as shown in (b) of FIG. 4, the target volume storage unit 181 stores, in the buffer 181a, the target volume d at the time when the moving average count Nav is changed, that is, the target volume d1a at the time of period change. At time t4, the target volume d1a at the time of period change is dn+3.

At time t4, the target volume storage unit 181 stores the target volume d1a at the time of period change as shown in FIG. 4. Within the changed average target period Tav, the target volume storage unit 181 sets the target volumes d previous to the target volume d1a at the time of period change to the latest current volume Vp, which is determined by the volume determination unit 183, before the target volume d1a at the time of period change is stored by the target volume storage unit 181.

The above-described changed average target period Tav is the average target period Tav corresponding to m times which is the changed moving average count Nav. The changed average target period Tav is the average target period Tav in which the target volume d1a at the time of period change is to be stored. The target volumes d, which are before the target volume d1a at the time of period change, indicate the target volumes d stored in the memory locations 181b of the target volume d at number 2 to number m.

As described above, the target volume storage unit 181 clears the buffer when the moving average count Nav is changed. The buffer clearing may be performed in other situations. Specifically, the target volume storage unit 181 executes the buffer clearing when a value of the target volume d is changed from the previous value of the target volume d. The previous value of the target volume d is the target volume d that is set in the previous control cycle. The target volume d set in the current control cycle is referred to as a current value of the target volume d.

There is an exception that when the target volume d is continuously changing, the buffer is not cleared in response to the change in the target volume d. For example, whether the target volume d is continuously changing or not is determined based on a volume difference Dv between the current value of the target volume d and the previous value of the target volume d. When the volume difference Dv between the current value of the target volume d and the previous value of the target volume d is less than a predetermined volume difference threshold, it is determined that the target volume d is changing continuously. When the volume difference Dv of the target volume d is equal to or greater than the volume difference threshold, it is determined that the change in the target volume d is not continuous, and the buffer clearing is performed. That is, when the target volume d is changed with respect to the previous value of the target volume d by the volume difference Dv equal to or greater than the volume difference threshold, the buffer clearing is performed.

The volume difference threshold is a positive value set in advance based on experimental result, so as to determine whether the change in the target volume d is continuous or not. The volume difference Dv between the current value of the target volume d and the previous value of the target volume d is a value expressed as an absolute value.

The buffer clearing executed in response to the change of target volume d is similar to the buffer clearing executed in response to the change of moving average count NaV. In the description of the present embodiment, when the target volume d is changed, the target volume d after the change is referred to as a changed target volume d2a for distinguishing purpose.

When the target volume d is changed not in a continuous manner, the target volume storage unit 181 performs the buffer clearing to store the latest current volume Vp in all memory locations 181b of the target volume d within the range of moving average count Nav in the buffer 181a, as shown in (a) of FIG. 4. Then, the target volume storage unit 181 stores the changed target volume d2a in the buffer 181a, as shown in FIG. (b) of FIG. 4.

When the target volume d is changed non-continuous manner, the target volume storage unit 181 stores the changed target volume d2a as shown in (b) of FIG. 4. At the same time, the target volume storage unit 181 sets all target volumes d that occur before the changed target volume d2a during the average target period Tav to the latest current volume Vp, which is determined by the volume determination unit 183 before the target volume storage unit 181 stores the changed target volume d2a.

When the target volume d is changed non-continuous manner and the moving average count Nav is changed at the same time, the changed target volume d2a and the target volume d1a at the time of period change indicate the same target volume d.

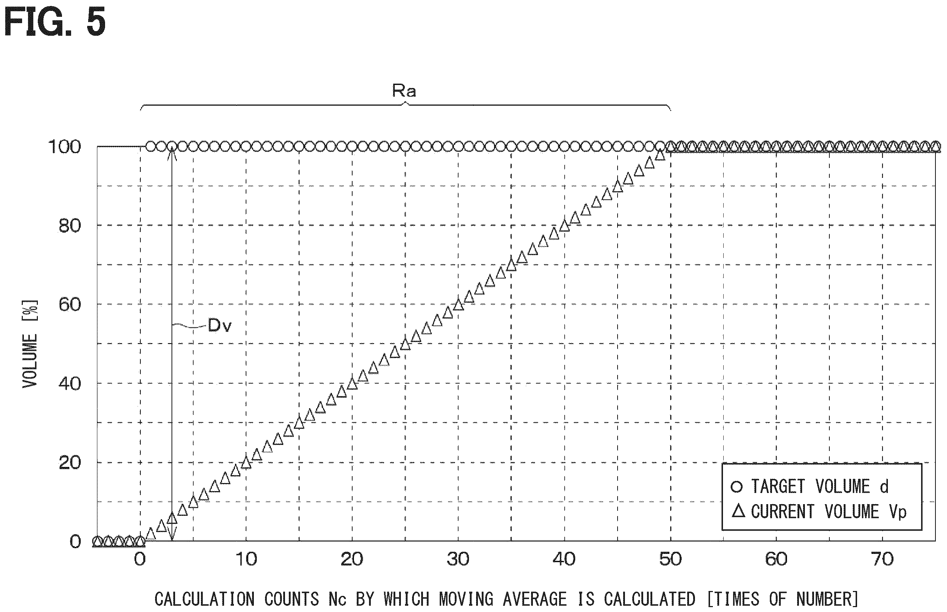

The following will describe a gradual change process for gradually changing the current volume Vp with reference to FIG. 5 to FIG. 9. In FIG. 5 to FIG. 9, the horizontal axis shows the number of calculations Nc that the volume determination unit 183 calculates the moving average of target volume d to determine the current volume Vp. The number of calculations Nc is also referred to as calculation count Nc. The elapsed time can be obtained by multiplying the calculation count Nc by the calculation cycle T1. Thus, the horizontal axis also indicates the elapsed time.

The first example of FIG. 5 shows a fade-in that linearly changes the current volume Vp. In the first example, the target volume d instructed from the sound generation instruction unit 16 to the volume control unit 18 is a constant value of 100%, and the gradual change duration is 1 sec. Therefore, the average target period Tav is set to 1 sec, which is the same as the gradual change duration. In the present embodiment, since the calculation cycle T1 is 20 msec, the moving average count Nav is 50 times, calculated by "Nav = 1/0.02".

In the first example, at the first calculation count Nc, which corresponds to the start point of gradual change process, the target volume d is changed relative to the previous value of target volume d, and the volume difference Dv between before and after the change is 100%, which is equal to or greater than the volume difference threshold. That is, the target volume d is changed in non-continuous manner. In the first example, the target volume d and the current volume Vp before the start of the gradual change process are 0%.

Thus, in the first calculation count Nc, the buffer clearing is performed. Since the latest current volume Vp is 0% (that is, silent), 0% is stored in all memory locations 181b of the target volume d in the buffer 181a. Then, after the buffer is cleared, the latest target volume d (specifically, 100%) which is the changed target volume d is stored in the buffer 181a. Using the buffer 181a stored as described above, the volume determination unit 183 determines, as the first current volume Vp, the moving average of target volumes during the average target period Tav.

From the second calculation count Nc, the buffer is not cleared, and the current volume Vp is sequentially determined by calculating the moving average of target volumes d. Then, the current volume Vp gradually increases over the calculation range Ra, which is the 1st to 50th calculation count Nc, and reaches the target volume d at the 50th calculation count Nc. After that, the current volume Vp remains at 100%, matching the target volume d.

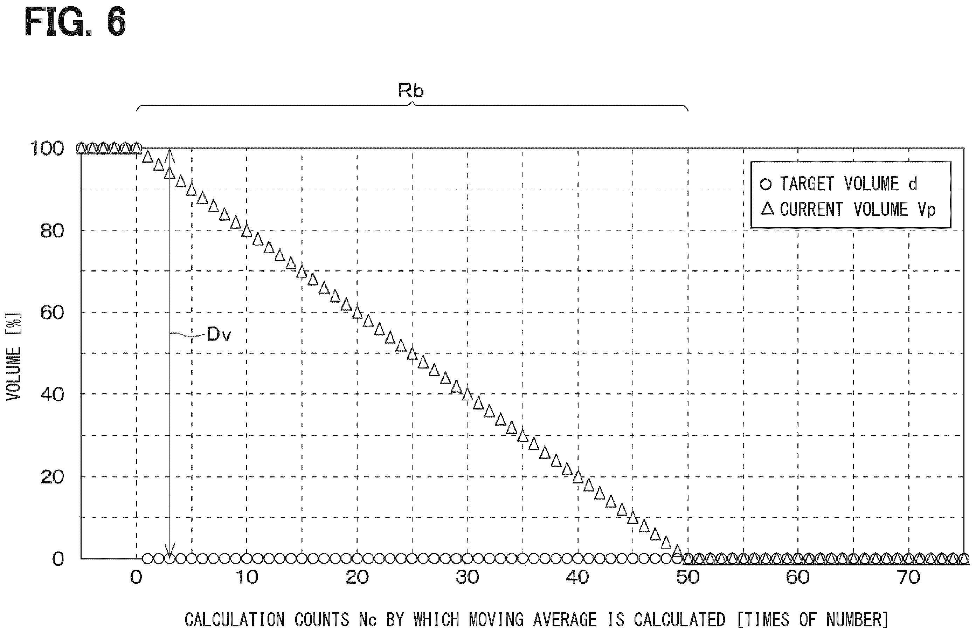

The following will describe a second example with reference to FIG. 6. The second example shows a fade-out that linearly changes the current volume Vp. In the second example, the target volume d instructed by the sound generation instruction unit 16 to the volume control unit 18 is a constant value of 0%, and the gradual change duration is 1 sec. Therefore, similarly to the first example described above, the average target period Tav is set to 1 sec, which is the same as the gradual change duration, and the moving average count Nav is set to 50 times.

In the second example, similar to the first example, in the first calculation count Nc, the target volume d is changed relative to the previous value of the target volume d, and the volume difference Dv between before and after the change is 100%, which is equal to or greater than the volume difference threshold. In the second example, the target volume d and the current volume Vp before the start of gradual change process are 100%.

Thus, in the first calculation count Nc, the buffer clearing is performed. Since the latest current volume Vp is 100% as shown in FIG. 6, 100% is stored in all memory locations 181b of the target volume d in the buffer 181a. Then, after the buffer is cleared, the latest target volume d (specifically, 0%) which is the changed target volume d is stored in the buffer 181a. Using the buffer 181a stored as described above, the volume determination unit 183 determines, as the first current volume Vp, the moving average of target volumes during the average target period Tav.

From the second calculation count Nc, the buffer clearing is not executed, and the current volume Vp is sequentially determined by calculating the moving average of target volumes d. Then, the current volume Vp gradually decreases over a count range Rb, which corresponds to the 1st to 50th calculation counts Nc, and reaches the target volume d at the 50th calculation count Nc. After that, the current volume Vp remains at 0%, matching the target volume d.

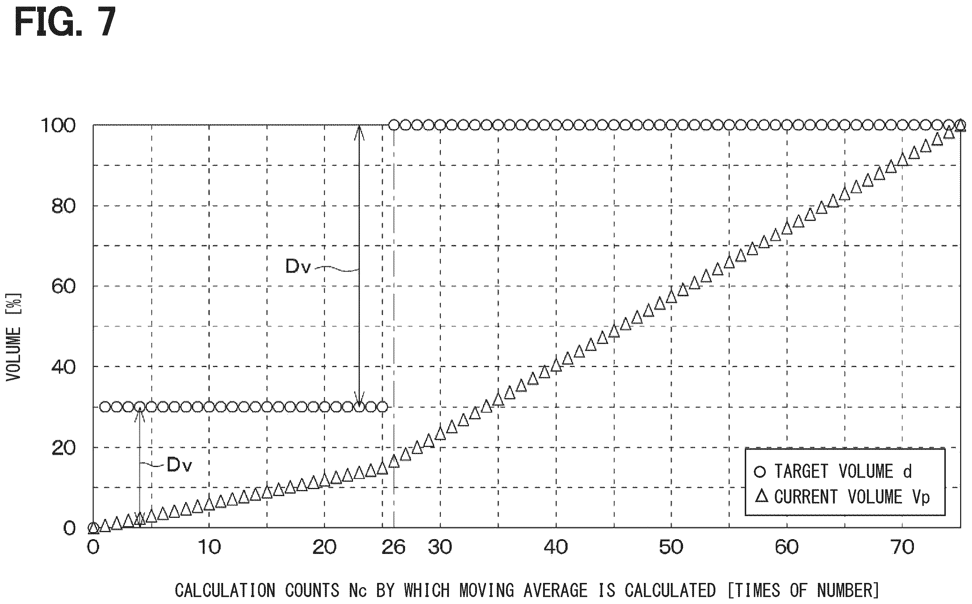

The following will describe a second example with reference to FIG. 7. The third example shows a fade-in. In the third example, the target volume d is changed in the middle of gradual change of the current volume Vp. In the third example, the target volume d instructed by the sound generation instruction unit 16 to the volume control unit 18 is initially a constant value of 30%, and the gradual change duration is 1 sec. Therefore, similarly to the first example described above, the average target period Tav is set to 1 sec, which is the same as the gradual change duration, and the moving average count Nav is set to 50. Then, the gradual change process of the current volume Vp is started.

In the third example, similar to the first example, in the first calculation count Nc, the target volume d is changed relative to the previous value of the target volume d, and the volume difference Dv between before and after the change is 30%, which is equal to or greater than the volume difference threshold. In the third example, similar to the first example, the target volume d and the current volume Vp before the start of gradual change process are 0%.

Therefore, in the first calculation count Nc, the buffer clearing is performed and then the latest target volume d (specifically, 30%), which is the changed target volume d, is stored in the buffer 181a. Then, similar to the first example, the volume determination unit 183 determines the moving average of target volumes d during the averaging target period Tav as the first current volume Vp.

From the second to the 25th calculation count Nc, the buffer clearing is not performed. The current volume Vp is determined sequentially by calculating the moving average of target volumes d, and the current volume Vp gradually increases. In the third example, between the 25th and 26th calculation counts Nc, the target volume d is changed from the initial 30% to a constant value of 100% by instruction from the sound generation instruction unit 16, and the gradual change duration is set to 1 see from the time the target volume d is changed. That is, the moving average count Nav remains at 50 counts.

Because the target volume d is increased from 30% to 100%, in the 26th calculation count Nc, the target volume d is changed from the previous value of target volume d, and the volume difference Dv between before and after the change is equal to or greater than the volume difference threshold. That is, the volume difference Dv between the target volume d at the 25th calculation count Nc and the target volume d at the 26th calculation count Nc is 70%, which is equal to or greater than the volume difference threshold.

Thus, in the 26th calculation count Nc, the buffer clearing is performed. Since the latest current volume Vp is the current volume Vp at the 25th calculation count Nc, the 25th current volume Vp is stored in all memory locations 181b of the target volume d in the buffer 181a. After the buffer is cleared, the latest target volume d, which is the changed target volume d, is stored in the buffer 181a. In the 26th calculation count Nc, the volume determination unit 183 uses the buffer 181a stored as described above to determine, as the current volume Vp, the moving average of target volumes d during the averaging target period Tav.

From the 27th calculation count Nc, the buffer clearing is not executed, and the current volume Vp is sequentially determined by calculating the moving average of target volumes d. Then, the current volume Vp gradually increases over the 26th to the 75th calculation count Nc, and then reaches the target volume d at the 75th calculation count Nc. Then, the current volume Vp remains at 100%, matching the target volume d.

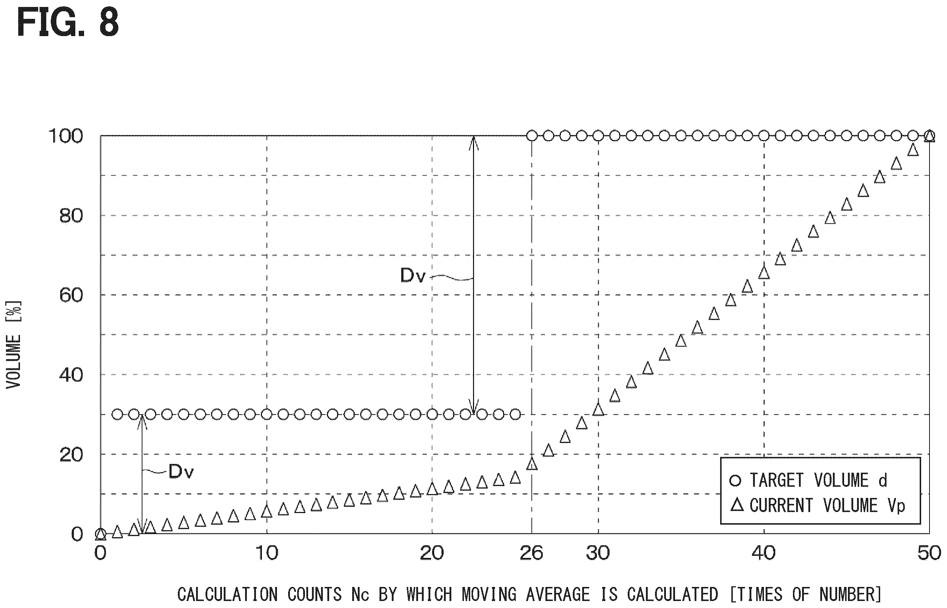

The following will describe a fourth example with reference to FIG. 8. The fourth example shows a fade-in like the third example. In the fourth example, the target volume d is changed in the middle of gradual change of the current volume Vp. In the fourth example, the end point of fade-in is maintained at the originally set point.

In the fourth example, the target volume d instructed by the sound generation instruction unit 16 to the volume control unit 18 is initially a constant value of 30%, and the gradual change duration is 1 sec. Therefore, similarly to the third example described above, the average target period Tav is set to 1 sec, which is the same as the gradual change duration, and the moving average count Nav is set to 50. Then, the gradual change process of the current volume Vp is started.

The buffer clearing is performed in the first calculation count Nc in the same manner as in the third example, and the current volume Vp changes from the first calculation count Nc to the 25th calculation count Nc in the same manner as in the third example. In the fourth example, similar to the third example, the target volume d and the current volume Vp before the start of gradual change process are 0%.

In the fourth example, between the 25th and 26th calculation counts Nc, the target volume d is changed from the initial 30% to a constant value of 100%, as in the third example, in response to instruction from the sound generation instruction unit 16. In the fourth example, unlike the third example, the gradual change duration remains at 1 sec from the start of gradual change (more specifically, fade-in) of the current volume Vp. Therefore, from the 26th calculation count Nc, the moving average count Nav is set to 25, which corresponds to the remaining time of the gradual change. In this case, the average target period Tav corresponding to the moving average count Nav from the 26th time is different from the gradual change duration.

In the fourth example, similar to the third example, since the target volume d is increased from 30% to 100%, in the 26th calculation count Nc, the target volume d is changed from the previous value of target volume d, and the volume difference Dv between before and after the change is equal to or greater than the volume difference threshold. Therefore, the buffer clearing is performed in the same manner as in the third example.

After the buffer clearing is performed, from the 26th calculation count Nc, the current volume Vp is sequentially determined by calculating the moving average of target volumes d. The fourth example differs from the third example in that the moving average count Nav used when calculating the moving average is 25 times. Therefore, in the fourth example, the current volume Vp gradually increases over the period from the 26th to the 50th calculation count Nc, and then reaches the target volume d at the 50th calculation count Nc. Thereafter, the current volume Vp remains at 100% and matches the target volume d.

In the fourth example, unlike the third example, the end point of gradual change process of the current volume Vp is not delayed from the point at which the gradual change process is originally scheduled to be ended. The original end time is scheduled at the start time of the gradual change process.

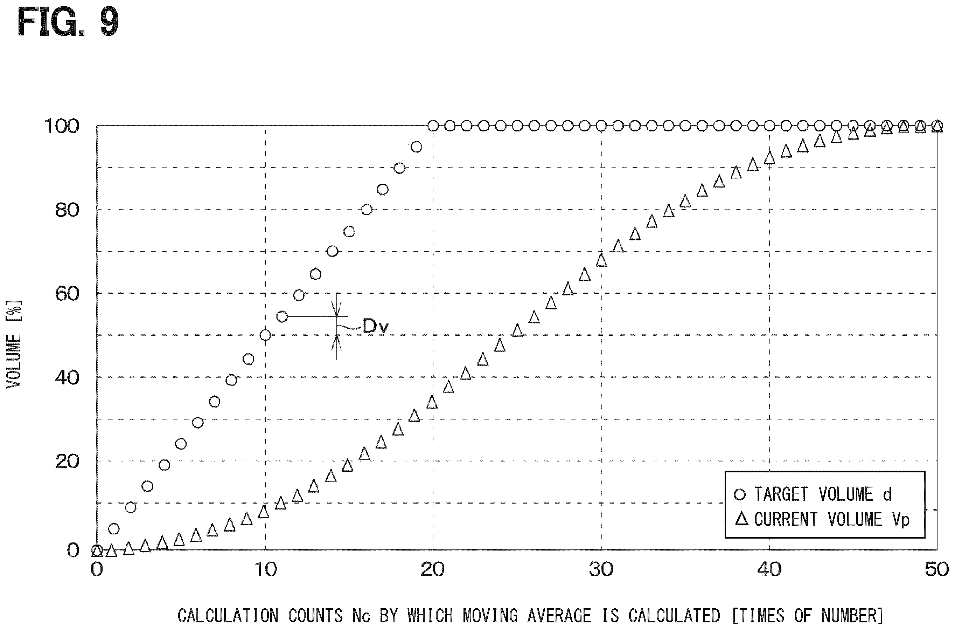

The following will describe a fifth example with reference to FIG. 9. In the fifth example, the target volume d is increased linearly (that is, linearly) from 0% to 100% up to the 20th calculation count Nc by instruction from the sound generation instruction unit 16 to the volume control unit 18, and then remains constant at 100% after the 20th calculation. The moving average count Nav is set to 30 times. In the present embodiment, since the calculation cycle T1 is 20 msec as described above, the average target period Tav is calculated as "Tav = 30 x 0.02" to be 0.6 sec.

In the fifth example, the target volume d is 0% before the start of gradual change process of the current volume Vp, and the target volume d is increased linearly from 0% to 100%, so that the volume difference Dv between the current value of the target volume d and the previous value of the target volume d is less than the volume difference threshold. Therefore, in the fifth example, the buffer clearing is not performed. In the fifth example, the current volume Vp before the gradual change process starts is 0%.

Then, the current volume Vp determined successively from the first calculation count Nc increases smoothly, and reaches the target volume d at the 50th calculation count Nc. Thereafter, the current volume Vp remains at 100% while remaining consistent with the target volume d. In the fifth example, the current volume Vp does not change linearly but changes like an S-curve as it increases, so that the change in the current volume Vp forms a more natural curve to the auditory perception.

As described above, according to the present embodiment, the target volume storage unit 181 sequentially stores and accumulates the target volume d, which is repeatedly set at a predetermined calculation cycle T1, in the buffer 181a. Then, the volume determination unit 183 sequentially determines, as the current volume Vp, the moving average of target volumes d during the average target period Tav among the target volumes d stored in the buffer 181a. The target volumes d are stored in the buffer 181a by the target volume storage unit 181. The current volume Vp indicates the volume of sound data Dsd.

Therefore, under the same computational structure of calculating the moving average of target volumes d, by changing the setting manner of the target volume d and the average target period Tav, it is possible to generate various gradual change patterns of the current volume Vp. That is, the sound generation system 8 of the present embodiment can provide various types of gradual volume change controls using the same calculation structure. It becomes possible to simplify the processing structure of the entire sound generation system 8, which leads to a reduction in the amount of data that needs to be stored in advance in the sound generation system 8.

For example, by appropriately adjusting the average target period Tav, it is possible to accommodate gradual volume change control for a typical fade-in time or fade-out time (for example, about 100 msec to a few seconds). By setting a short average target period Tav (for example, about 100 msec), it is also possible to reduce the discomfort and abnormal noise that occurs when the sound source data Dss is quickly switched or the current volume Vp is quickly changed to reach the target volume d. It is also possible to prevent discomfort caused by a sudden change in the target volume d due to a change in the vehicle state.

According to the present embodiment, when the target volume d is changed relative to the previous value of target volume d in a non-continuous manner, the target volume storage unit 181 stores the changed target volume d2a, as shown in (b) of FIG. 4. At the same time, the target volume storage unit 181 sets all target volumes d that occur before the changed target volume d2a during the average target period Tav to the latest current volume Vp, which is determined by the volume determination unit 183 before the target volume storage unit 181 stores the changed target volume d2a.

Therefore, when the target volume d is changed in a stepwise manner, a sudden change in the current volume Vp is prevented, and the current volume Vp can be changed in continuous manner with respect to the volume before the change in the target volume d. For example, as shown in FIG. 7, even when the target volume d is changed in the middle of the gradual change process of current volume Vp, the current volume Vp can be changed in continuous manner.

When the target volume d is changed in continuous manner, the process of setting all target volumes d, which are prior to the above-described changed target volume d2a, to the latest current volume Vp is not executed although the target volume d is changed. Thus, even when the change in the target volume d is continuous change, the present embodiment can appropriately deal with the continuous change.

According to the present embodiment, when the average target period Tav is changed, the target volume storage unit 181 stores the target volume d1a at the time of period change as shown in (b) of FIG. 4. Within the changed average target period Tav, the target volume storage unit 181 sets the target volumes d previous to the target volume d1a at the time of period change to the latest current volume Vp, which is determined by the volume determination unit 183, before the target volume d1a at the time of period change is stored by the target volume storage unit 181.

Therefore, when the average target period Tav is changed, a sudden change in the current volume Vp is prevented, and the current volume Vp can be changed so as to be continuous with respect to the volume before the average target period Tav is changed.

### (Other Embodiments)

(1) In the above embodiment, when the target volume d is changed relative to the previous value of target volume d, the buffer clearing is performed. As an exception, when the target volume d is continuously changing, specifically when the volume difference Dv between the current value of target volume d and the previous value of target volume d is less than the predetermined volume difference threshold, buffer clearing is not performed due to the change in the target volume d. This is one example, and it is contemplated that there will be no such exception.
(2) In the above embodiment, each process executed by the microcomputer 10 is implemented by a computer program, but it may also be implemented by hardware circuits.
(3) In the above embodiment, the sound generation system 8 is described as a warning device mounted on an automobile. However, this is merely an example. The sound generation system 8 does not have to be a warning device, and various uses of the sound generation system 8 are envisioned. The sound generation system 8 does not have to be equipped to a vehicle.
(4) The present disclosure is not limited to the above-described embodiment, and can be implemented in various modifications. Individual components or features of the above-described embodiment are not necessarily essential unless it is specifically stated that the components or the features are essential in the foregoing description, or unless the components or the features are obviously essential in principle.

The numerical value such as the number, value, quantity, range, or the like of components mentioned in the above-described embodiment is not limited to a specific number unless specified as being required, clearly limited to such a specific number in principle, or the like. The material, the shape, the positional relationship, and the like of a component or the like mentioned in the above embodiment are not limited to those being mentioned unless otherwise specified, or limited to specific material, shape, positional relationship, and the like in principle.

## Claims

1. A volume control device included in a sound generation system (8), the sound generation system controlling a sound generator (80) to generate a sound based on sound data (Dsd), the volume control device controlling a volume (Vp) of the sound data, the volume control device comprising:
a target volume storage unit (181) configured to store and accumulate target volumes (d) repeatedly set at a predetermined period (T1); and
a volume determination unit (183) configured to sequentially determine, as the volume of the sound data, a moving average of the target volumes accumulated in the target volume storage unit during a predetermined average target period (Tav).

2. The volume control device according to claim 1, wherein,
when a change occurs in the target volumes, the target volume storage unit stores a changed target volume (d2a), which is the target volume changed relative to a previous value of the target volume, and sets all of the target volumes, which are prior to the changed target volume within the average target period corresponding to the changed target volume, to a latest volume of the sound data determined by the volume determination unit before the changed target volume is stored by the target volume storage unit.

3. The volume control device according to claim 1, wherein,
when a change occurs in the target volumes by a volume difference (Dv) of a predetermined threshold or greater relative to a previous value of the target volume, the target volume storage unit stores a changed target volume (d2a), which is the target volume changed relative to the previous value of the target volume, and sets all of the target volumes, which are prior to the changed target volume within the average target period corresponding to the changed target volume, to a latest volume of the sound data determined by the volume determination unit before the changed target volume is stored by the target volume storage unit.

4. The volume control device according to any one of claims 1 to 3, wherein,
when a change occurs in the average target period, the target volume storage unit stores a target volume (d1a) at a time of period change, which is the target volume set when the average target period is changed, and sets all of the target volumes, which are prior to the target volume at the time of period change within the average target period corresponding to the target volume at the time of period change, to a latest volume of the sound data determined by the volume determination unit before the target volume at the time of period change is stored by the target volume storage unit.
